# EUROPEAN PATENT APPLICATION

(11) **EP 2 804 232 A1**
(43) Date of publication of application: **19.11.2014**
(21) Application number: 13382181.9
(22) Date of filing: 16.05.2013
(51) Int. Cl.: H01L 51/42, C01G 21/16, C07F 7/24

(54) **High performance perovskite-sensitized mesoscopic solar cells**

(71) Applicant: Abengoa Research S.L., 41014 Sevilla (ES)
(72) Inventor: Burschka, Julian Alexander, 1025 Saint Sulpice (CH); Pellet, Norman, 1800 Vevey (CH); Nazeeruddin, Mohammad Khaja, 1024 Ecublens (CH); Graetzel, Michael, 1025 Saint Sulpice (CH); Ahmad, Shahzada, E-41014 Sevilla (ES)
(74) Representative: ABG Patentes, S.L.

(57) **Abstract**

The present invention relates to methods for preparing sensitized solar cells using organic-inorganic perovskites as sensitizers.

## Description

### Field of the Invention

The present invention concerns solar cells, in particular sensitized solar cells, organic-inorganic perovskite films and/or layers, heterojunctions, working electrodes, photoanodes, and methods for producing the same. The invention further relates to methods of applying organic-inorganic perovskites on a mesoscopic, nanoporous and/or nanostructured surface.

### Background of the invention and Problems to be solved

Dye-sensitized solar cells (DSCs) are one of the most promising third-generation photovoltaic (PV) technologies.¹ Solid-state DSC embodiments have emerged as viable contenders where the electrolyte is replaced by a solid state hole transporting material (HTM), such as the triarylamine derivative 2,2',7,7'-tetrakis(*N,N*-di-p-methoxyphenylamine)-9,9'-spirobifluorene (spiro-MeOTAD)² or more recently a tin halide pervoskite.³

Despite achieving remarkable power-conversion efficiencies (PCEs) of 7%⁴ and 8.5 %³ for the spiro-MeOTAD and tin halide perovskite based systems, respectively, the performance of solid-state DSCs has so far been lagging behind their liquid counterparts that presently reach a PCE of 12.3 %.⁵ The difference arises mainly from the 10-100 times faster charge carrier recombination in the solid-state device compared to the liquid electrolyte based counterpart. In order to collect most of the photogenerated charge carriers the thickness of the nanocrystalline oxide film is usually kept below 3 µm reducing the light harvesting by the molecular sensitizer and hence the short-circuit photocurrent (J_{sc}) and conversion efficiency of the device.⁶ Inspired by inorganic thin-film photovoltaics, many attempts have been made to increase the optical absorption cross-section of the light harvesters in the solid-state DSC. One approach is to replace the molecular sensitizer by semiconductor quantum dots, such as PbS, CdS or Sb₂S₃, where the semiconductor nanoparticles often assume a dual role of absorbing light and transporting charge carriers.⁷ While the performance of quantum dot based solar cells has progressed recently in an impressive manner reaching a PCE of 7.5% ⁸, it remains still below that of other solid-state mesoscopic photovoltaics.

Recently, Kojima et al. introduced solution-processable hybrid organic-inorganic perovskites of the formular CH₃NH₃PbX₃ (X = Br, I) as sensitizers for DSCs reaching a PCE of 3.8% in conjunction with mesoporous TiO₂ and a iodide/triiodide based liquid electrolyte.⁹ Im et al. later improved the PCE to 6.5% by optimizing the composition of the redox electrolyte.¹⁰ In both cases, the photovoltaic devices suffered from poor stability due to the rapid dissolution of the perovskite in the liquid electrolyte. This problem could be overcome by using a solid-state configuration, employing the aforementioned spiro-MeOATD as a hole transporter. In this manner Kim et al. achieved a PCE of 9%.¹¹ At the same time, Lee et al. showed that such a device works even better when the semiconducting mesoporous TiO₂ film was replaced by an insulating Al₂O₃ scaffold, indicating rapid electron transport through the perovskite phase.¹² While reaching an impressive PCE of 10.9 % with their champion cell, Lee et al. reported on very poor reproducibility and a large spread of photovoltaic device performance. Since the publication of these pioneering studies, several investigations have followed up on this concept.¹³⁻¹⁹ In all this previous work, the perovskite pigment was applied from a of a solution of the two precursors, PbX₂ (X = I, Br or Cl) and CH₃NH₃I, in a common solvent, i.e. N,N-dimethylformamid (DMF) or y-butyrolactone (GBL).

From our own experience, we find that there is a lack of control of the morphology of the perovskite crystals formed during this kind of solution processing, which is most likely the reason for the poor reproducibility of PV cell performance.

The present invention addresses disadvantages of devices comprising liquid electrolytes, such as the problem of solvent evaporation and the penetration of water into the solar cell caused by difficulty in long-term sealing especially in temperature cyclic tests.

It is a further objective of the invention to provide solar cells, in particular solid state solar cells having yet higher conversion efficiencies than prior art devices. A light to electrical power energy conversion efficiency (η) of about 10% was suggested to be a level necessary for commercial use.

The invention seeks to provide an efficient solar cell that can be prepared rapidly in an efficient, reproducible way, using readily available, low-cost materials, using a short manufacturing procedure based on industrially known manufacturing steps.

The present invention addresses the problems of stability observed with certain sensitized solar cells.

### Summary of the invention

Remarkably, we report a new sequential deposition technique to produce organic-inorganic perovskite films on nanoporous surfaces.

In an aspect, the invention provides methods comprising: a step of applying and/or depositing a film comprising and/or consisting essentially of one or more divalent or trivalent metal salts; and a step of applying and/or depositing one or more ammonium halide salts or inorganic halide salts.

The invention provides methods comprising the steps of:
a) applying and/or depositing a film comprising and/or consisting essentially of one or more divalent or trivalent metal salts; and.
b) applying and/or depositing one or more organic ammonium salts, wherein steps a) and b) may be conducted in any order, and in said a) and/or b), said one or more divalent or trivalent metal salts and/or said one or more organic ammonium salts is applied and/or deposited on a nanoporous layer and/or surface.

According to an embodiment, the invention provides more specifically the steps of:
c) applying and/or depositing a film comprising and/or consisting essentially of one or more divalent or trivalent metal salt on a nanoporous layer;
d) exposing and or contacting the film obtained in step a) to a solution comprising one or more organic ammonium salts in a solvent.

In an aspect, the invention provides a method for producing a solar cell, the method comprising the steps a) and b) of the invention.

In an aspect, the invention provides a method for applying and/or producing a sensitizer on a nanoporous surface and/or layer, the method comprising the steps a) and b) of the invention.

In an aspect, the invention provides a method for applying and/or producing a perovskite layer on a nanoporous surface and/or layer, the method comprising the steps a) and b) of the invention.

In an aspect, the invention provides a method for coating a nanoporous layer and/or a semiconductor layer, the method comprising the steps a) and b) of the invention.

In an aspect, the invention provides a method for producing a photoanode and/or a working electrode, for example for a solar cell, the method comprising the steps a) and b) of the invention.

In an aspect, the invention provides a method for producing a heterojunction, the method comprising the steps a) and b) of the invention.

In an aspect, the invention provides a method for producing a nanocrystalline organic-inorganic perovskite layer, the method comprising the steps a) and b) of the invention.

In an aspect, the invention provides a method for applying and/or producing a perovskite layer on a surface and/or layer having any one or more of the following characteristics:
- the layer/surface has a surface area per gram ratio of 20 to 200 m²/g, preferably 30 to 150 m²/g, and most preferably 60 to 120 m²/g;
- the layer/surface comprises and/or is prepared from nanoparticles, such as nanosheets, nanocolumns and/or nanotubes;
- the layer/surface is nanocrystalline;
- the layer/surface is mesoporous;
- the layer/surface has an overall thickness of 10 to 3000 nm, preferably 15 to 1500 nm, more preferably 20 to 1000 nm, still more preferably 50 to 800 nm and most preferably 100 to 500 nm;
- the surface has a porosity of 20 to 90%, preferably 50 to 80%;
- the surface comprises and/or consists essentially of one or more selected from a metal oxide, a transition metal oxide, and a semiconductor material;
the method comprising the steps a) and b) of the invention.

In an aspect, the present invention provides a method for producing a solar cell, the method comprising the steps of:
- providing a current collector and a nanoporous layer;
- applying and/or depositing a film comprising and/or consisting essentially of one or more divalent or trivalent metal salts;
- exposing and/or contacting the film obtained in the previous step to a solution comprising one or more organic ammonium salts in a solvent, thereby obtaining a layer comprising an organic-inorganic perovskite; and
- providing a counter electrode.

In an aspect, the invention provides a method for producing a solar cell, the method comprising the steps of:
- providing a current collector;
- applying and/or depositing a film comprising and/or consisting essentially of one or more divalent or trivalent metal salts;
- applying and/or depositing a layer comprising one or more ammonium salts; and
- providing a counter electrode;
wherein said one or more divalent or trivalent metal salts and/or said one or more ammonium salts are deposited on a nanopourous layer, forming an organic-inorganic perovskite layer.

In an aspect, the invention provides a method for producing a nanocrystalline organic-inorganic perovskite layer, the method comprising the steps of:
- providing a nanoporous layer;
- applying and/or depositing a film comprising and/or consisting essentially of one or more divalent or trivalent metal salts on said nanoporous scaffold layer;
- exposing the film obtained in the previous step to a solution comprising one or more organic ammonium salts in a solvent, thereby obtaining said organic-inorganic perovskite on said nanoporous scaffold layer.

In an aspect, the invention provides a method for producing a nanocrystalline organic-inorganic perovskite layer, the method comprising the steps of:
- applying and/or depositing a film comprising one or more divalent or trivalent metal salts;
- applying and/or depositing a layer comprising one or more ammonium salts; and,
- providing a counter electrode;
wherein said one or more divalent or trivalent metal salts and/or said one or more ammonium salts are deposited on a nanopourous layer, forming an organic-inorganic perovskite layer on said nanoporous layer.

In an aspect, the invention provides a nanocrystalline organic-inorganic perovskite layer.

In further aspects, the invention provides organic-inorganic perovskite layer and solar cells obtainable by the methods of the invention.

In further aspects, the present invention provides a solar cell comprising a current collector, a nanoporous layer, a nanoporous scaffold structure, a perovskite layer and a counter electrode.

In an aspect, the invention provides a solar cell comprising a nanoporous layer and an organic-inorganic perovskite layer in contact with said nanoporous layer, wherein said perovskite comprises an organic-inorganic perovskite forming crystals of a length of < 50 nm, preferably < 45 nm, more preferably < 40 nm.

In an aspect, the invention provides solar cell comprising organic-inorganic perovskite layer in contact with a nanoporous layer, wherein said solar cell exhibits a power conversion efficiency (PCE) of ≥ 12%, preferably ≥ 13% when exposed to AM1.5G light.

### Brief Description of the Drawings

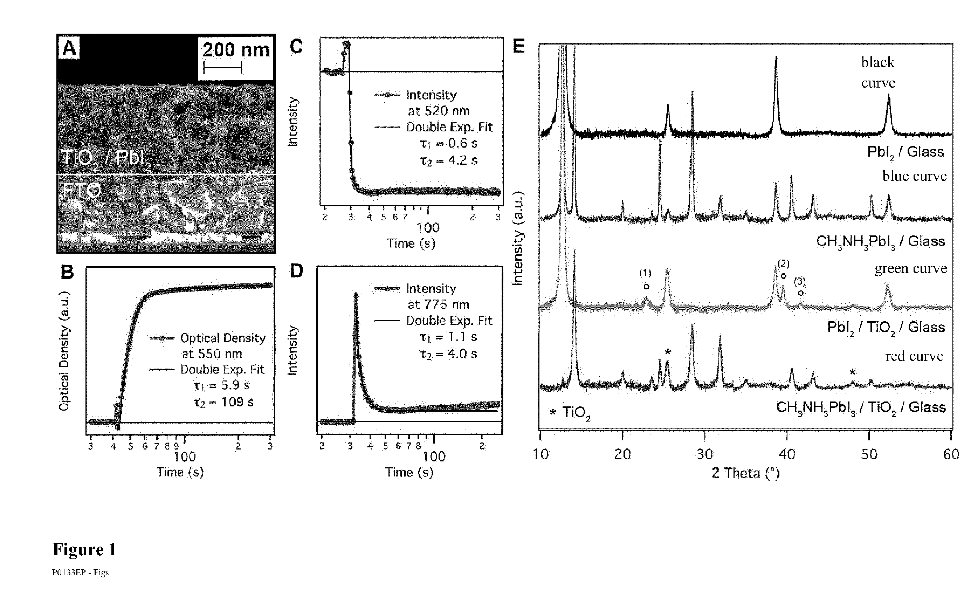

**Figure 1** illustrates the transformation of PbI₂ into CH₃NH₃PbI₃ within the nanopores of a mesoscopic TiO₂ film in accordance with an embodiment of the invention described in the examples section. A) Cross-sectional SEM of a mesoporous TiO₂ film infiltrated with PbI₂. B) Change in optical density at 550 nm of such a film monitored during the transformation. C) Change in emission intensity at 520 nm monitored during the transformation. Excitation at 460 nm. D) Change in emission intensity at 775 nm monitored during the transformation. Excitation at 660 nm. E) X-ray diffraction spectra of PbI₂ on glass and porous TiO₂/glass before and after the transformation. The dipping time was 60 s in both cases.
**Figure 2** shows a cross-sectional SEM of a complete photovoltaic device of an embodiment of the present invention. Note that the thin TiO₂ compact layer present between the FTO and the mesoscopic composite is not resolved in the SEM image.

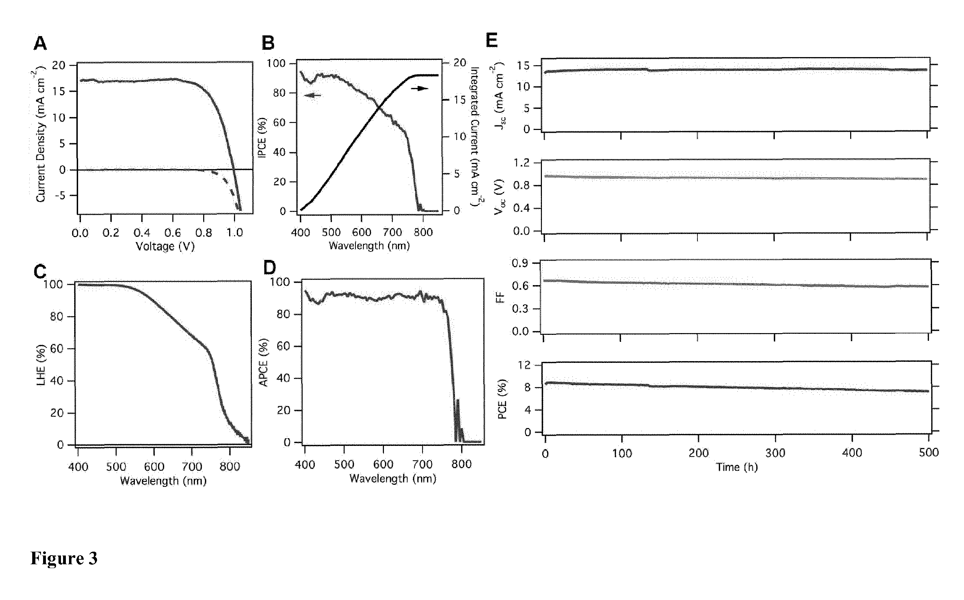

**Figure 3** shows photovoltaic device characterization and long-term stability of solar cells according to embodiments of the invention. A) JV curves of a photovoltaic device measured at 95.6 mW cm⁻² simulated AM1.5G solar irradiation (solid line) and in the dark (dotted line). B) IPCE spectrum. The right axis indicates the integrated photocurrent that is expected to be generated under AM1.5G irradiation. C) LHE spectrum. D) APCE spectrum derived from the IPCE and LHE. E) Evolution of photovoltaic parameters under constant illumination at approximately 100 mW cm⁻² and 45 °C. During the ageing the device is maintained at its MPP using MPP-tracking.
**Figure 4** shows JV characteristics of a champion solar cell reaching 15% PCE in accordance with an embodiment of the invention. JV-curves were measured at 96.4 mW cm⁻² simulated AM1.5G solar irradiation (solid line) and in the dark (dotted line).
**Figure 5** shows SEM photographs of AMX₂ perovskite crystals deposited on fluorine-doped tin oxide glass substrate obtained by way of a two-step process (E-F) and AMX₂ crystals obtained in a single step method (A-D) for comparison.
**Figures 6A and B** show *J-V* curves of solar cells according to an embodiment of the present invention at 100mWcm⁻² illumination, before (A) and after (B) 500 h of aging. *J-V* curves are measured under the same white LED light that is used for the stability test.
**Figures 7A** and **7B** show different embodiments of solar cells of the invention.

### Detailed description of the Preferred Embodiments

The present invention encompasses the formation of an organic-inorganic perovskite layer.

Preferably, the organic-inorganic perovskite layer is provided on a surface and/or on a layer. Preferably, said surface and/or layer is structured, for example structured on a nanoscale.

The nanostructured layer may also be referred to as a scaffold, as it preferably forms the support of the perovskite layer to be deposited and/or applied thereon. For example, the nanostructured layer may be referred to as a nanostructured or nanoporous scaffold or scaffold layer, for example. Furthermore, the nanostructured layer preferably has a nanostructured surface.

According to an embodiment, said the nanostructured layer has a surface area per gram ratio of 20 to 200 m²/g, preferably 30 to 150 m²/g, and most preferably 60 to 120 m²/g.

According to an embodiment, the nanoporous layer comprises and/or is prepared from nanoparticles, such as spherical nanoparticles, nanosheets, nanocolumns, nanotubes and/or nanoparticles of any other geometrical shape. The nanoparticles preferably have average dimensions and/or sizes in the range of 2 to 300 nm, preferably 3 to 200 nm, even more preferably 4 to 150 nm, and most preferably 5 to 100 nm. "Dimension" or "size" with respect to the nanoparticles means here extensions in any direction of space, preferably the average maximum extension of the nanoparticles. In case of substantially spherical or ellipsoid particles, the average diameter is preferably referred to. In case of nanosheets, the indicated dimensions refer to the length and thickness. Preferably, the size of the nanoparticles is determined by transmission electron microscopy (TEM), scanning-electron microscopy (SEM) or Brunauer-Emmett-Teller (BET) surface area analysis as disclosed by Etgar et al.

According to an embodiment, the layer is nanocrystalline. According to an embodiment, the surface is mesoporous. According to an embodiment, the surface is nanoporous.

According to an embodiment, the layer has a porosity of 20 to 90%, preferably 50 to 80% as determined by Brunauer-Emmett-Teller (BET) surface area analysis.

According to an embodiment, the nanoporous layer comprises and/or consists essentially of one or more selected from a metal oxide, a transition metal oxide, and a semiconductor material.

According to an embodiment, the nanoporous surface or layer has an overall thickness of 10 to 3000 nm, preferably 15 to 1500 nm, more preferably 20 to 1000 nm, still more preferably 50 to 800 nm and most preferably 100 to 500 nm.

According to an embodiment, the nanoporous layer comprises or consists essentially of Si, SiO₂, TiO₂, Al₂O₃, Ga₂O₃, Y₂O₃, In₂O₃, ZrO₂, HfO₂, SnO₂, Fe₂O₃, ZnO, WO₃, MoO₃, Nb₂O₅, CdS, ZnS, PbS, Bi₂S₃, CdSe, CdTe, SrTiO₃, GaP, InP, GaAs, CuInS₂, CuInSe₂, CaTiO₃, SrTiO₃, BaSnO₃, Zn₂SnO₄, and combinations thereof.

According to a preferred embodiment, the nanoporous layer comprises, consists essentially of or consists of one or more selected from Si, TiO₂, SnO₂, Fe₂O₃, ZnO, WO₃, Nb₂O₅, CdS, ZnS, PbS, Bi₂S₃, CdSe, CdTe, SrTiO₃, GaP, InP, GaAs, CuInS₂, CuInSe₂, and combinations thereof.

Still more preferred materials of the nanoporous layer are Si, TiO₂, SnO₂, ZnO, WO₃, Nb₂O₅ and SrTiO₃, for example. TiO₂, is most preferred.

The skilled person is aware of how to produce layers and/or surfaces having one or more of the above specified characteristics, for example nanoporous or nanostructured surfaces. For example, the layer may be prepared by screen printing or spin coating, for example as is conventional for the preparation of porous semiconductor (e.g. TiO₂) layers in dye-sensitized solar cells, see for example, Thin Solid Films 516, 4613-4619 (2008) or Etgar et al., Adv. Mater. 2012, 24, 2202-2206. Nanoporous semiconductor structures and layers have been disclosed, for example, in EP 0333641 and EP 0606453.

In case a solar cell is to be produced, the nanostructured layer or scaffold is preferably provided on a current collector or on an underlayer, said underlayer being provided on a current collector.

Said nanostructured layer and/or said perovskite layer is preferably in electric contact with said current collector.

For the purpose of the present specification, the expression "in electric contact with" means that electrons or holes can get from one layer to the other layer with which it is in electric contact, at least in one direction. In particular, considering the electron flow in the operating device exposed to electromagnetic radiation, layers through which electrons and/or holes are flowing are considered to be in electric contact. The expression "in electric contact with" does not necessarily mean that electrons and/or holes can freely move in any direction between the layers.

According to an embodiment, the solar cell of the invention preferably comprises one or more support layer. The support layer preferably provides the physical support of the device. Furthermore, the support layer preferably provides a protection with respect to physical damage and thus delimits the solar cell with respect to the outside, for example on at least one of the two major sides of the solar cell. According to an embodiment, the solar cell may be constructed by applying the different layers in a sequence of steps, one after the other, onto the support layer. The support layer may thus also serve as a starting support for the fabrication of the solar cell. Support layers may be provided on only one or on both opposing sides of the solar cell.

The support layer, if present, is preferably transparent, so as to let light pass through the solar cell. Of course, if the support layer is provided on the side of the solar cell that is not directly exposed to light to be converted to electrical energy, the support does not necessarily have to be transparent. However, any support layer provided on the side that is designed and/or adapted to be exposed to light for the purpose of energy conversion is preferably transparent. "Transparent" means transparent to at least a part, preferably a major part of the visible light. Preferably, the support layer is substantially transparent to all wavelengths or types of visible light. Furthermore, the support layer may be transparent to non-visible light, such as UV and IR radiation, for example.

Conveniently, and in accordance with a preferred embodiment of the invention, a conducting support layer is provided, said conducting support layer serving as support as described above as well as current collector. The conducting support layer thus replaces or contains the support layer and the current collector. The conducting support layer is preferably transparent. Examples of conducting support layers are conductive glass or conductive plastic, which are commercially available. For example, the conducting support layer comprises a material selected from indium doped tin oxide (ITO), fluorine doped tinoxide (FTO), ZnO-Ga₂O₃, ZnO-Al₂O₃, tin-oxide, antimony doped tin oxide (ATO), SrGeO₃ and zinc oxide, coated on a transparent substrate, such as plastic or glass.

According to another embodiment, the current collector may also be provided by a conductive metal foil, such as a titanium or zinc foil, for example. Non-transparent conductive materials may be used as current collectors in particular on the side of the device that is not exposed to the light to be captured by the device. Such metal foils have been used as current collectors, for example, in flexible devices, such as those disclosed by Seigo Ito et al, Chem. Commun. 2006, 4004-4006.

According to a preferred embodiment, the nanoporous layer is provided on an underlayer and/or metal oxide layer. Preferably, the underlayer is provided between the current collector and said nanoporous layer. Preferably, the underlayer is conductive. The underlayer may be made from a metal oxide. Preferably, it is preferably made from a dense or compact semiconductor material. The underlayer may be made from the same materials as the nanoporous scaffold layer, but is typically less porous and denser. The underlayer may facilitate the application of the nanoporous layer and/or surface.

The underlayer preferably has a thickness of 1-120 nm (nanometer). It may be applied, for example, by atomic layer deposition (ALD). In this case, the thickness of this layer is preferably 1 nm to 25 nm. The underlayer may also be deposited by spray pyrolysis, for example, which typically results in a thickness of preferably 10 nm to 120 nm.

The method of the invention preferably comprises the steps of:
a) applying and/or depositing a film comprising one or more divalent or trivalent metal salts; and
b) applying and/or depositing one or more organic ammonium salts, wherein steps a) and b) may be conducted in any order, and in said a) and/or b), said one or more divalent or trivalent metal salt and/or said one or more organic ammonium salt is applied and/or deposited on said nanoporous layer and/or surface.

According to an embodiment, said one or more divalent or trivalent metal salts are selected from salts of formula MX₂ or NX₃, wherein:
M is a divalent metal cation selected from the group consisting of Cu²⁺, Ni²⁺, Co²⁺, Fe²⁺,
Mn²⁺, Cr²⁺, Pd²⁺, Cd²⁺, Ge²⁺, Sn²⁺, Pb²⁺, Eu²⁺, or Yb²⁺;
N is selected from the group of Bi³⁺ and Sb³⁺;
any X is independently selected from Cl⁻, Br⁻, I⁻, NCS⁻, CN⁻, and NCO⁻.
Preferably, said metal salt is MX₂.

According to a preferred embodiment, said metal salt is a metal halide. Preferably, in case two or more different metal salts are used, these are different metal halides.

According to an embodiment, said organic ammonium is selected from AX and BX₂, A being an organic, monovalent cation selected from primary, secondary, tertiary or quaternary organic ammonium compounds, including N-containing heterorings and ring systems, A having from 1 to 60 carbons and 1 to 20 heteroatoms; and B being an organic, bivalent cation selected from primary, secondary, tertiary or quaternary organic ammonium compounds having from 1 to 60 carbons and 2 to 20 heteroatoms and having two positively charged nitrogen atoms. Preferably, said organic ammonium is selected from AX.

Preferred embodiments for A, B, M, N and X are disclosed elsewhere in this specification, for example with respect to preferred perovskites of the invention.

In the method of the invention, step a) is preferably conducted before step b), but the present invention also encompasses, in other embodiments, that step b) is conducted first and step a) thereafter.

According to an embodiment, said film of said one or more divalent or trivalent metal salt is applied and/or deposited (step a)) by any one or more selected from: deposition from solution, deposition from a dispersion, for example, from a colloidal dispersion, deposition by thermal evaporation, deposition by sputtering, electrodeposition, atomic-layer-deposition (ALD), and formation of the metal salt in situ, respectively, in-situ. The latter comprises the possibility of applying and/or depositing the divalent or trivalent metal salt in a two or multistep process, for example by depositing a precursor onto the surface that is subsequently transformed into the divalent or trivalent metal salt.

Examples of deposition from solution encompass, for example, drop casting, spin-coating, dip-coating, curtain coating, spray-coating, and ink-jet printing for example.

According to an embodiment, said film of a divalent or trivalent metal salt is applied and/or deposited by spin-coating a solution of one or more said metal salts at 2'000 rpm or more, preferably 3'000 rpm or more. Said spin-coating may take place at 4'000 rpm or more, preferably 5'000 rpm or more and most preferably at 5'500 rpm or more, for example 6'000 rpm or more. Preferably, said spin-coating takes place for 1 s (second) to 10 minutes, preferably 2 s to 30 s.

When more than one divalent metal salts are applied and/or deposited, the two different salts may be applied at the same time. For example, in case of deposition from a solution, the solution may contain different metal salts. Said different metals salts preferably differ with respect to the anion. Accordingly, metals salts MXⁱ₂ and MXⁱⁱ₂, or for example metals salts MXⁱ₂, MXⁱⁱ₂ and MXⁱⁱⁱ₂ are deposited at the same time, for example are present in the same solution, M being a defined metal and Xⁱ, Xⁱⁱ and Xⁱⁱⁱ being different anions selected from the above, preferably different halides. For example, Xⁱ, Xⁱⁱ and Xⁱⁱⁱ are I⁻, Cl⁻ and Br⁻, respectively.

According to an embodiment, the method of the invention comprises the steps of applying and/or depositing a film comprising two or more selected from MXⁱ₂ MXⁱⁱ₂ and MXⁱⁱⁱ₂, wherein Xⁱ, Xⁱⁱ and Xⁱⁱⁱ (charge not shown) are each different anions selected from I⁻, Cl⁻, Br⁻, I⁻, NCS⁻, CN⁻, and NCO⁻, preferably from I⁻, Cl⁻, and Br⁻.

A mixed perovskite is obtained if the metal salt film comprising MXⁱ₂ and MXⁱⁱ₂, or MXⁱ₂, MXⁱⁱ₂ and MXⁱⁱⁱ₂, for example, may be exposed to an organic ammonium salt in accordance with the invention, which may be selected, independently from any one of AXⁱ, AXⁱⁱ and AXⁱⁱⁱ.

Preferably, if the metal salt film comprises MXⁱ₂ and MXⁱⁱ₂, the organic ammonium salt is selected from salts comprising one of the anions contained in the metal salt layer, for example from AXⁱ or AXⁱⁱ.

According to an embodiment, the method of the invention comprises the step (e.g. step a)) of applying and/or depositing a film comprising MI₂ and one selected from MCl₂ and MBr₂. For example, MI₂ and MCl₂ or MI₂ and MBr₂, respectively, are deposited from the same solution in which they are dissolved. According to an embodiment, the method of the invention comprises the step (e.g. step b)) of applying AI to the metals halide obtained in the previous step. Preferably, M is Pb and/or A is CH₃NH₃⁺.

According to another embodiment, the method of the invention comprises the step (e.g. step a)) of applying and/or depositing a film comprising MCl₂ and one selected from MI₂ and MBr₂. For example, MCl₂ and MI₂ or MCl₂ and MBr₂, respectively, are deposited from the same solution in which they are dissolved. According to an embodiment, the method of the invention comprises the step (e.g. step b)) of applying ACl to the metals halide obtained in the previous step. Preferably, M is Pb and/or A is CH₃NH₃+.

According to a preferred embodiment, step b) comprises applying and/or depositing one single and/or one structurally defined organic ammonium salt. Preferably, not a mixture of different organic salts is applied and/or deposited. This is preferably valid irrespective from whether a mixture of different metal salts or if a single type of metal salts was deposited in the method of the invention.

In accordance with an embodiment, in step a) a mixture of MⁱX₂ with MⁱⁱX or MⁱⁱⁱX₃ may be applied, said MⁱX₂ and one from MⁱⁱX and MⁱⁱⁱX₃ being preferably applied together/at the same time, for example deposited from the same solution. In this case Mⁱⁱ and Mⁱⁱⁱ represent monovalent or trivalent cations, which would constitute a doping with a monovalent or trivalent metal salt, respectively. In the result, n-type or p-type doped metal salts and eventually perovskites can be obtained.

In accordance with the above said two different metal salts may be applied, differing with respect to the metal, but having, for example, identical anions. In this case, metals carrying different charges are preferably applied, resulting in doped perovskites.

According to an embodiment, before exposing the applied and/or deposited film of said divalent or trivalent metal salt (for example MX₂ or NX₃, respectively) to said organic ammonium salt solution, said metal salt is pre-wetted by exposing it to a solvent in the absence of said organic ammonium salt. The solvent used for pre-wetting is preferably the same as the solvent in which said organic ammonium salt is dissolved as disclosed elsewhere in this specification, or is otherwise a solvent in which said metal salt is not or not easily soluble.

The invention comprises the step b) of applying and/or depositing an organic ammonium salt on a nanoporous layer. If step b) is conducted after step a), it preferably comprises or consists essentially of the step of exposing or contacting the film obtained in step a) to a solution comprising one or more organic ammonium salts in a solvent.

The solvent for producing the solution comprising said one or more organic ammonium salts is preferably selected from solvents that are good solvents for the organic ammonium salt to be dissolved but a bad solvent for the divalent or trivalent metal salt, in particular MX₂ or NX₃. The solvent is preferably also a bad solvent (does not dissolve) for the resulting perovskite.

The one or more divalent or trivalent metal salts may be exposed to or contacted with said solution comprising the organic ammonium salt by dipping the crystals and/or metal salt into said solution. For example, the nanoporous layer comprising the deposited metal salt (e.g. MX₂ or NX₃) layer may be dipped into said solution of the organic ammonium salt. According to an embodiment, said metal salt film is exposed to or contacted with said solution for 10 minutes or less, preferably 5 minutes or less, even more preferably 1 minute or less, or for the time periods given in the paragraph below.

According to an embodiment, said organic-inorganic perovskite is formed within < 120 s, preferably < 60 s following exposure to said solution. More preferably, said organic-inorganic perovskite is formed within < 45 s, preferably < 30 s following exposure to said solution. In the case of dipping, the nanoporous layer comprising the deposited metal salt layer may be dipped into said solution for the time periods indicated above (< 120 s, etc.). Exposure time (contacting, dipping) is preferably conducted for at least one second, more preferably at least two second.

Surprisingly, the method of the invention yields metal salt crystals, in particular MX₂ or NX₃ crystals, and eventually perovskite crystals, of smaller sizes, for example of shorter length than the respective crystals reported in the prior art. "Size" or "length", for the purpose of the present specification, refer to the maximum extension along an axis, and is preferably expressed in nanometers (nm).

According to an embodiment, the size of crystals of said metal salt film and/or of said organic-inorganic perovskite obtained in the method of the invention are < 50 nm, preferably < 45 nm, more preferably < 40 nm. Still more preferably, said crystals are < 35 nm, preferably < 30 nm, most preferably < 25 nm.

Preferably, the majority of the crystals have the indicated size, more preferably at least 70% of the crystals. Most preferably, crystals, which are longer than indicated above (for example, > 50 or > 45 nm, etc), are substantially or totally absent, in particular inside the pores of said nanoporous layer, but preferably in the perovskite layer as a whole.

According to an embodiment, the layer comprising said perovskite and/or said layer comprising said sensitizer is substantially free of said divalent or trivalent metal salt. In other words, the conversion into the perovskite is complete and occurs within the above-indicated time periods, for example within 25 seconds or 20 seconds. This applies in particular in case of MX₂ contacted with AX, yielding the AMX₃ perovskite as described elsewhere in this specification.

According to an embodiment, the crystals formed during the step of applying and/or depositing said divalent or trivalent metal salt, MX₂ or NX₃, respectively, comprise 2H polytype crystals on said nanoporous scaffold layer. In addition, said MX₂ or NX₃ are present in the form of and/or contain additional crystals, which are different from said 2H polytype. Surprisingly, such other crystals are absent when said metal salt is deposited on a flat surface or a surface that is different from the nanostructured layer and/or surface of the invention.

According to an embodiment, the organic-inorganic perovskite material that is used and/or obtained in the one or more perovskite layer preferably comprises a perovskite-structure of any one of formulae (I), (II), (III), (IV), (V) and/or (VI) below:

AA'MX₄ (I)

AMX₃ (II)

AA'N_{2/3}X₄ (III)

AN_{2/3}X₃ (IV)

BN_{2/3}X₄ (V)

BMX₄ (VI)

wherein A' is independently selected from the same monovalent organic cations as A, and A and B are as described elsewhere in this specification.

In formulae AA'N_{2/3}X₄, AN_{2/3}X₃ and BN_{2/3}X₄, "2/3" means every third metal cation is missing. In this case, the perovskite is metal deficient.

Preferably, M is Sn²⁺ or Pb²⁺, more preferably Pb²⁺. N is preferably selected from the group of Bi³⁺ and Sb³⁺.

In the perovskites of formulae (I) to (VI), any X (for example any one X in X₄) may be selected independently from Cl⁻, Br⁻, I⁻, NCS⁻, CN⁻, and NCO⁻. Preferably, X is halogen, preferably X is selected from Br⁻ or I⁻.

According to an embodiment, all anions in "X₃" and "X₄" are identical.

According to a preferred embodiment, "X₃" and "X₄" contain at least two different anions.

According to a preferred embodiment, "X₃" comprises two or more halides, in particular two. Preferably, X₃ is Xⁱ₂Xⁱⁱ, with Xⁱ₂ and Xⁱⁱ being independently selected from halides, preferably from Cl⁻, Br and I-. Preferably, "X₃" is selected from I₂Cl or I₂Br, forming perovskites AMI₂Cl and AMI₂Br, respectively.

According to an embodiment, A and A' are identical, resulting in perovskite of the formulae A₂MX₄, A₂PbX₄, A₂SnX₄, for formulae (I), (VIII) and (IX) (see below), for example. Preferably, A and A' are identical and all X are identical.

According to a preferred embodiment, the perovskite material has the structure selected from one or more of formulae (I) to (III), preferably (II).

According to a preferred embodiment, said organic-inorganic perovskite layer comprises a perovskite-structure of any one of the formulae (V), (VI), (VII), (VIII), (IX), (X) and (XI) below:

APbX₃ (V)

ASnX₃ (VI)

ABi X₄ (VII)

AA'PbX₄ (VIII)

AA'SnX₄ (IX)

BPbX₄ (X)

BSnX₄ (XI)

wherein A, A', B and X are as defined elsewhere in this specification. Preferably, X is preferably selected from Br and I⁻, most preferably X is I⁻.

According to a preferred embodiment, said organic-inorganic perovskite layer comprises a perovskite-structure of the formulae (V) to (IX), more preferably (V) and/or (VI) above.

According to an embodiment, A and A', for example in AX and/or in any one of formulae (I) to (III), and (V) to (IX), are monovalent cations selected independently from any one of the compounds of formulae (1) to (8) below: 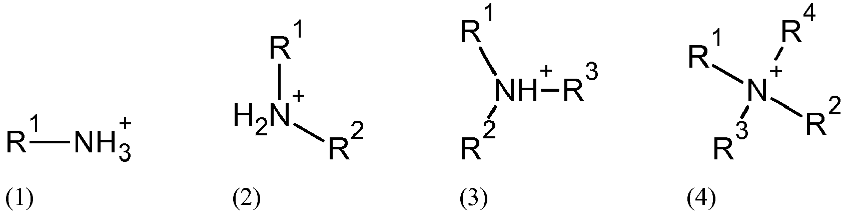 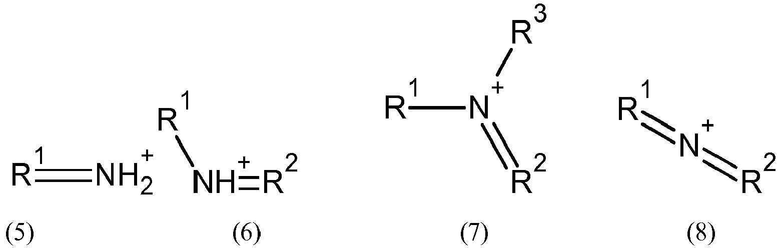 wherein,
any one of R¹, R², R³ and R⁴ is independently selected from C1-C15 organic substituents comprising from 0 to 15 heteroatoms.

According to an embodiment of said C1-C15 organic substituent any one, several or all hydrogens in said substituent may be replaced by halogen and said organic substituent may comprise up to fifteen (15) N, S or O heteroatoms, and wherein, in any one of the compounds (2) to (8), the two or more of substituents present (R¹, R², R³ and R⁴, as applicable) may be covalently connected to each other to form a substituted or unsubstituted ring or ring system. Preferably, in a chain of atoms of said C1-C15 organic substituent, any heteroatom is connected to at least one carbon atom. Preferably, neighboring heteroatoms are absent and/or heteroatom-heteroatom bonds are absent in said C1-C15 organic substituent comprising from 0 to 15 heteroatoms.

According to an embodiment any one of R¹, R², R³ and R⁴ is independently selected from Cl to C 15 aliphatic and C4 to C 15 aromatic or heteroaromatic substituents, wherein any one, several or all hydrogens in said substituent may be replaced by halogen and wherein, in any one of the compounds (2) to (8), the two or more of the substituents present may be covalently connected to each other to form a substituted or unsubstituted ring or ring system.

According to an embodiment, B is a bivalent cation selected from any one of the compounds of formulae (9) and (10) below: 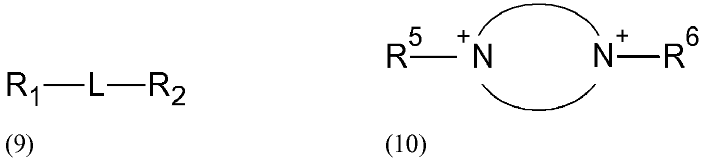 wherein,
in the compound of formula (9), L is an organic linker structure having 1 to 10 carbons and 0 to 5 heteroatoms selected from N, S, and/or O, wherein any one, several or all hydrogens in said L may be replaced by halogen;
wherein any one of R₁ and R₂ is independently selected from any one of the substituents (20) to (25) below: 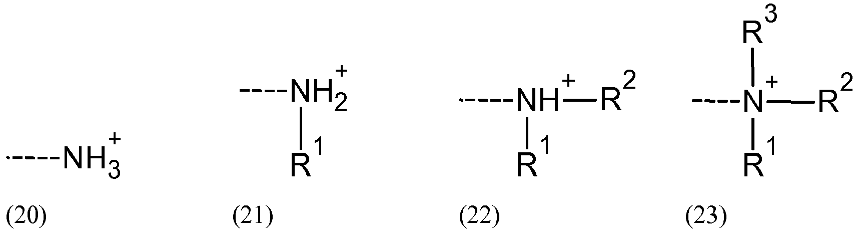 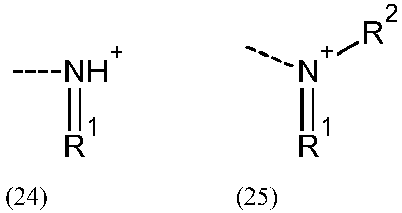 wherein the dotted line in the substituents (20) to (25) represents the bond by which said substituent is connected to the linker structure L;
wherein R¹, R², and R³ are independently as defined above with respect to the compounds of formulae (1) to (8);
wherein R₁ and R², if they are both different from substituent (20), may be covalently connected to each other by way of their substituents R¹, R², and/or R³, as applicable, and wherein any one of R¹, R², and R³, if present, may be covalently connected to L or the ring structure of compound (10), independently from whether said substituent is present on R₁ or R₂;
and wherein, in the compound of formula (10), the circle containing said two positively charged nitrogen atoms represents a substituted or unsubstituted aromatic ring or ring system comprising 4 to 15 carbon atoms and 2 to 7 heteroatoms, wherein said nitrogen atoms are ring heteroatoms of said ring or ring system, and wherein the remaining of said heteroatoms may be selected independently from N, O and S and wherein R⁵ and R⁶ are independently selected from H and from substituents as R¹ to R⁴. Halogens substituting hydrogens totally or partially may also be present in addition to and/or independently of said 2 to 7 heteroatoms.

Preferably, if the number of carbons is in L is impair, the number of heteroatoms is smaller than the number of carbons. Preferably, in the ring structure of formula (10), the number of ring heteroatoms is smaller than the number of carbon atoms.

According to an embodiment, L is an aliphatic, aromatic or heteroaromatic linker structure having from 1 to 10 carbons.

Preferably, the dotted line in substituents (20) to (25) represents a carbon-nitrogen bond, connecting the nitrogen atom shown in the substituent to a carbon atom of the linker.

According to an embodiment, in the compound of formula (9), L is an organic linker structure having 1 to 8 carbons and from 0 to 4 N, S and/or O heteroatoms, wherein any one, several or all hydrogens in said L may be replaced by halogen. Preferably, L is an aliphatic, aromatic or heteroaromatic linker structure having 1 to 8 carbons, wherein any one, several or all hydrogens in said L may be replaced by halogen.

According to an embodiment, in the compound of formula (9), L is an organic linker structure having 1 to 6 carbons and from 0 to 3 N, S and/or O heteroatoms, wherein any one, several or all hydrogens in said L may be replaced by halogen. Preferably, L is an aliphatic, aromatic or heteroaromatic linker structure having 1 to 6 carbons, wherein any one, several or all hydrogens in said L may be replaced by halogen.

According to an embodiment, in the compound of formula (9), said linker L is free of any O or S heteroatoms. According to an embodiment, L is free ofN, O and/or S heteroatoms.

According to an embodiment, in the compound of formula (10), the circle containing said two positively charged nitrogen atoms represents a substituted or unsubstituted aromatic ring or ring system comprising 4 to 10 carbon atoms and 2 to 5 heteroatoms (including said two ring N-atoms).

According to an embodiment, said ring or ring system in the compound of formula (10) is free of any O or S heteroatoms. According to an embodiment, said ring or ring system in the compound of formula (10) is free of any further N, O and/or S heteroatoms, besides said two N-ring atoms. This does not preclude the possibility of hydrogens being substituted by halogens.

As the skilled person will understand, if an aromatic linker, compound, substituent or ring comprises 4 carbons, it comprises at least 1 ring heteroatom, so as to provide an aromatic moiety.

According to an embodiment, any one of R¹, R², R³ and R⁴ is independently selected from C1 to C8 organic substituents comprising, from 0 to 4 N, S and/or O heteroatom, wherein, independently of said N, S or O heteroatoms, any one, several or all hydrogens in said substituent may be replaced by halogen, and wherein two or more of substituents present on the same cation may be covalently connected to each other to form a substituted or unsubstituted ring or ring system. Preferably, any one of R¹, R², R³ and R⁴ is independently selected from C1 to C8 aliphatic, C4 to C8 heteroaromatic and C6 to C8 aromatic substituents, wherein said heteroaromatic and aromatic substituents may be further substituted.

According to an embodiment, any one of R¹, R², R³ and R⁴ is independently selected from C1 to C6 organic substituents comprising, from 0 to 3 N, S and/or O heteroatom, wherein, independently of said N, S or O heteroatoms, any one, several or all hydrogens in said substituent may be replaced by halogen, and wherein two or more of substituents present on the same cation may be covalently connected to each other to form a substituted or unsubstituted ring or ring system. Preferably, any one of R¹, R², R³ and R⁴ is independently selected from C1 to C6 aliphatic, C4 to C6 heteroaromatic and C6 to C6 aromatic substituents, wherein said heteroaromatic and aromatic substituents may be further substituted.

According to an embodiment, any one of R¹, R², R³ and R⁴ is independently selected from C1 to C4, preferably C1 to C3 and most preferably C1 to C2 aliphatic substituents wherein any one, several or all hydrogens in said substituent may be replaced by halogen and wherein two or more of substituents present on the same cation may be covalently connected to each other to form a substituted or unsubstituted ring or ring system.

According to an embodiment, any one of R¹, R², R³ and R⁴ is independently selected from C1 to C10 alkyl, C2 to C10 alkenyl, C2 to C10 alkynyl, C4 to C10 heteroaryl and C6 to C10 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R¹-R⁴ may be replaced by halogen.

According to an embodiment, any one of R¹, R², R³ and R⁴ is independently selected from C1 to C8 alkyl, C2 to C8 alkenyl, C2 to C8 alkynyl, C4 to C8 heteroaryl and C6 to C8 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R¹-R⁴ may be replaced by halogen.

According to an embodiment, any one of R¹, R², R³ and R⁴ is independently selected from C1 to C6 alkyl, C2 to C6 alkenyl, C2 to C6 alkynyl, C4 to C6 heteroaryl and C6 aryl, wherein said alkyl, alkenyl, and alkynyl, if they comprise 3 or more carbons, may be linear, branched or cyclic, wherein said heteroaryl and aryl may be substituted or unsubstituted, and wherein several or all hydrogens in R¹-R⁴ may be replaced by halogen.

According to an embodiment, any one of R¹, R², R³ and R⁴ is independently selected from C1 to C4 alkyl, C2 to C4 alkenyl and C2 to C4 alkynyl, wherein said alkyl, alkenyl and alkynyl, if they comprise 3 or more carbons, may be linear, branched or cyclic, and wherein several or all hydrogens in in R¹-R⁴ may be replaced by halogen.

According to an embodiment, any one of R¹, R², R³ and R⁴ is independently selected from C1 to C3, preferably C1 to C2 alkyl, C2 to C3, preferably C2 alkenyl and C2 to C3, preferably C2 alkynyl, wherein said alkyl, alkenyl and alkynyl, if they comprise 3 or more carbons, may be linear, branched or cyclic, and wherein several or all hydrogens in R¹-R⁴ may be replaced by halogen.

According to an embodiment, any one of R¹, R², R³ and R⁴ is independently selected from C1 to C4, more preferably C1 to C3 and even more preferably C1 to C2 alkyl. Most preferably, any one of R¹, R², R³ and R⁴ are methyl. Again, said alkyl may be completely or partially halogenated.

According to an embodiment, A, A' and B are monovalent (A, A') and bivalent (B) cations, respectively, selected from substituted and unsubstituted C5 to C6 rings comprising one, two or more nitrogen heteroatoms, wherein one (for A and A') or two (for B) of said nitrogen atoms is/are positively charged. Substituents of such rings may be selected from halogen and from C1 to C4 alkyls, C2 to C4 alkenyls and C2 to C4 alkynyls as defined above, preferably from C1 to C3 alkyls, C3 alkenyls and C3 alkynyls as defined above. Said ring may comprise further heteroatoms, which may be selected from O, N and S. Bivalent organic cations B comprising two positively charged ring N-atoms are exemplified, for example, by the compound of formula (10) above. Such rings may be aromatic or aliphatic, for example.

A, A' and B may also comprise a ring system comprising two or more rings, at least one of which being from substituted and unsubstituted C5 to C6 ring as defined as above. The elliptically drawn circle in the compound of formulae (10) may also represent a ring system comprising, for example, two or more rings, but preferably two rings. Also if A and/or A' comprises two rings, further ring heteroatoms may be present, which are preferably not charged, for example.

According to an embodiment, however, the organic cations A, A' and B comprise one (for A, A'), two (for B) or more nitrogen atom(s) but are free of any O or S or any other heteroatom, with the exception of halogens, which may substitute one or more hydrogen atoms in cation A and/or B.

A and A' preferably comprise one positively charged nitrogen atom. B preferably comprises two positively charged nitrogen atoms.

A, A' and B may be selected from the exemplary rings or ring systems of formulae (30) and (31) (for A) and from (32) to (34) (for B) below: 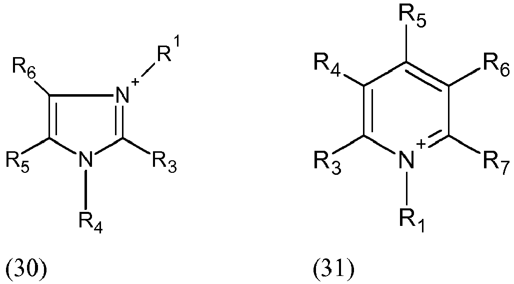 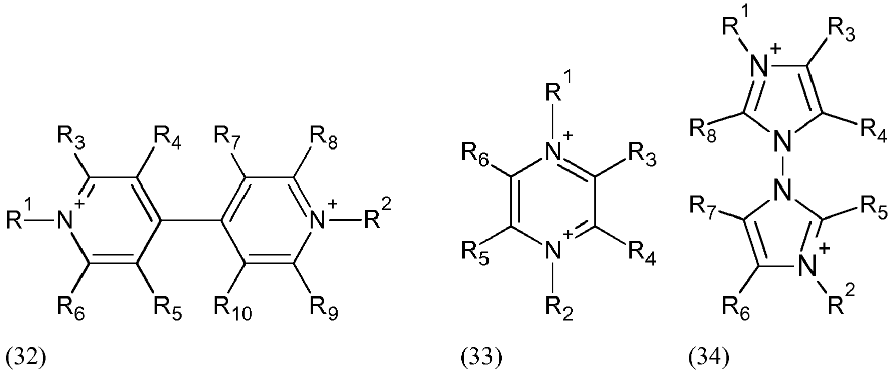 in which R¹ and R² are, independently, as defined above, and R₃, R₄, R₅, R₆, R₇, R₈, R₉ and R₁₀ are independently selected from H, halogen and substituents as defined above for R¹ to R⁴. Preferably, R₃-R₁₀ are selected from H and halogen, most preferably H.

In the organic cations A, A' and B, hydrogens may be substituted by halogens, such as F, Cl, I, and Br, preferably F or Cl. Such a substitution is expected to reduce the hygroscopic properties of the perovskite layer or layers and may thus provide a useful option for the purpose of the present specification.

Concerning the solar cells of the invention and the methods of producing them, said solar cell preferably comprises an intermediate layer selected from (a) a hole transport material, (b) a protective layer and (c) an ionic liquid, said intermediate layer being applied after obtaining said perovskite layer. The intermediate layer is preferably applied after and/or onto the perovskite layer.

By "hole transport material", "hole transporting material", "charge transporting material", "organic hole transport material" and "inorganic hole transport material", and the like, is meant any material or composition wherein charges are transported by electron or hole movement (electronic motion) across said material or composition. The "hole transport material" is thus an electrically conductive material. Such hole transport materials, etc., are different from electrolytes. In the latter, charges are transported by diffusion of molecules.

According to a preferred embodiment of the solar cell of the invention, said intermediate layer comprises a hole transport material selected from organic and inorganic hole transport materials.

According to a preferred embodiment, said intermediate layer comprises an organic hole transport material. Preferably, the solar cell of the invention comprises an intermediate layer, in particular an organic hole transport material, situated between said one or more perovskite layer and a counter electrode.

The skilled person is aware of a large variety of organic hole transport materials, such as the conducting polymers disclosed elsewhere in this specification. For example, in WO007107961, a liquid and non-liquid organic hole conductor are disclosed, which may be used for the purpose of the present invention. Also in EP 1160888 and other publications organic hole transport materials ("organic electrically conducting agent") are disclosed.

Preferred organic hole transport materials for the purpose of the present invention are are Spiro-OMeTAD (2,2',7,7'-tetrakis-*N,N*-di-p-methoxyphenylamine-9,9'-spirobifluorene) and derivatives of PTAA (poly(triarlyamine)) such as (Poly[bis(4-phenyl)(2,4,6-trimethylphenyl)amine]) or (Poly[bis(4-phenyl)(4-butylphenyl)amine]). US 2012/0017995, disclosing further hole transport materials, is entirely incorporated herein by reference.

It is noted that the term "organic" in expressions "organic hole transport material", "organic hole transport layer", "organic charge transport material" and the like does not exclude the presence of further components. Further components may be selected from (a) one or more dopants, (b) one or more solvents, (c) one or more other additives such as ionic compounds, and (c) combinations of the aforementioned components, for example. In the organic charge transport material, such further components may be present in amounts of 0-30wt.%, 0-20wt.%, 0-10wt.%, most preferably 0-5wt.%.

Examples of ionic compounds that may be present in organic hole transport materials are TBAPF₆, Na CF₃SO₃, Li CF₃SO₃, LiClO₄ and Li[(CF₃SO₂)₂N.

Examples of other compounds that may be present in organic hole transport materials are amines, 4-tertbutylpyridine, 4-nonyl-pyridine, imidazole, N-methyl benzimidazole, for example.

According to another embodiment, the intermediate layer comprises and/or consists essentially of an inorganic hole transport material. A wide variety of inorganic hole transport materials is commercially available. Non-limiting examples of inorganic hole transport materials are CuNCS, CuI, MoO₃, and WoO₃. The inorganic hole transport material may or may not be doped.

According to an embodiment, the intermediate layer, for example said organic or inorganic hole transport material, removes holes from the perovskite material and/or provides new electrons from the counter electrode to the sensitizer. In other terms, the hole transport material transports electrons from the counter electrode to the perovskite material layer.

The intermediate layer may comprise and/or consist essentially of a protective layer. According to an embodiment, the protective layer preferably comprises a metal oxide. In particular, the protective layer may comprise or consist essentially of a material selected from Mg-oxide, Hf-oxide, Ga-oxide, In-oxide, Nb-oxide, Ti-oxide, Ta-oxide, Y-oxide and Zr-oxide. Ga-oxide is a preferred material for said protective layer. The protective layer preferably has a thickness of not more than 5 nm, preferably 4 nm or less, even more preferably 3 nm or less, and most preferably 2 nm or less. According to preferred embodiments, the protective layer has a thickness of 1.5 nm or less, and even 1 nm or less. Said metal "protective layer" is preferably a "buffer layer".

According to an embodiment, of the solar cell and/or heterojunction of the invention said protective layer is provided by atomic layer deposition (ALD). For example, 2 to 7 layers are deposited by ALD so as to provide said protective layer. Accordingly, said protective layer is preferably a metal oxide multilayer.

According to an embodiment, the protective layer is as disclosed in the pending international application PCT/IB2011/055550, filed on December 8, 2011, which is entirely incorporated herein by reference.

According to another embodiment, the intermediate layer is absent and said counter electrode and/or metal layer is in direct contact with said perovskite layer and/or not separated by any further layer or medium from said perovskite layer.

The counter electrode faces the inorganic-organic perovskite layer or, if present, the intermediate layer towards the inside of the cell. The counter electrode may form the outmost layer and thus one of the outer surfaces of the cell. It is also possible that a substrate or support layer is present on one side of counter electrode.

The counter electrode generally comprises a catalytically active material, suitable to provide electrons and/or fill holes towards the inside of the device. The counter electrode may, for example, comprise one or more materials selected from (the group consisting of) Pt, Au, Ni, Cu, Ag, In, Ru, Pd, Rh, Ir, Os, C, conductive polymer, conductive oxide such as indium doped tin oxide (ITO), fluorine doped tin oxide (FTO), ZnO-Ga₂O₃, ZnO-Al₂O₃, tin-oxide, antimony doped tin oxide (ATO), SrGeO₃, and a combination of two or more of the aforementioned, for example. Conductive polymers may be selected from polymers comprising polyaniline, polypyrrole, polythiophene, polybenzene, polyethylenedioxythiophene, polypropylenedioxy-thiophene, polyacetylene, and combinations of two or more of the aforementioned, for example. Such conductive polymers may be used as hole transport materials.

The counter electrode may be applied as is conventional, for example by thermal evaporation of the counter electrode material onto the perovskite layer or onto the intermediate layer, if present.

The counter electrode is preferably connected to a current collector, which is then connected to the external circuit. As detailed with respect to the first side of the device, a conductive support such as conductive glass or plastic may be electrically connected to the counter electrode on the second side.

The solar cell of the invention is preferably a solid state solar cell.

The solar cell of the invention is preferably a sensitized solar cell, such as a dye-sensitized solar cell (DSC), in which said organic-inorganic perovskite is and/or functions as a dye and/or sensitizer.

According to an embodiment, solar cell according to an embodiment of the invention exhibits a power conversion efficiency (PCE) of ≥ 13.5%, preferably ≥ 14%, more preferably ≥ 14.5%, and most preferably ≥ 15%, when exposed to AM1.5G light. Preferably, PCE is ≥ 14.2%, ≥ 14.4%, ≥ 14.6%, ≥ 14.8%. PCE is preferably determined as disclosed in the examples and under the conditions specified therein.

The photoanode and/or working electrode of the solar cell of the invention may be formed by the nanoporous layer, optionally together with the perovskite layer. According to an embodiment, the photoanode and/or working electrode is formed by the perovskite. This applies, for example, if the nanoporous layer is not a semiconductor and/or is not conducting, but fulfils exclusively a surface-increasing function and/or a structural support function for the perovskite. In this case, the perovskite layer is preferably also in direct physical contact with said underlayer and/or is in electric contact with said current collector.

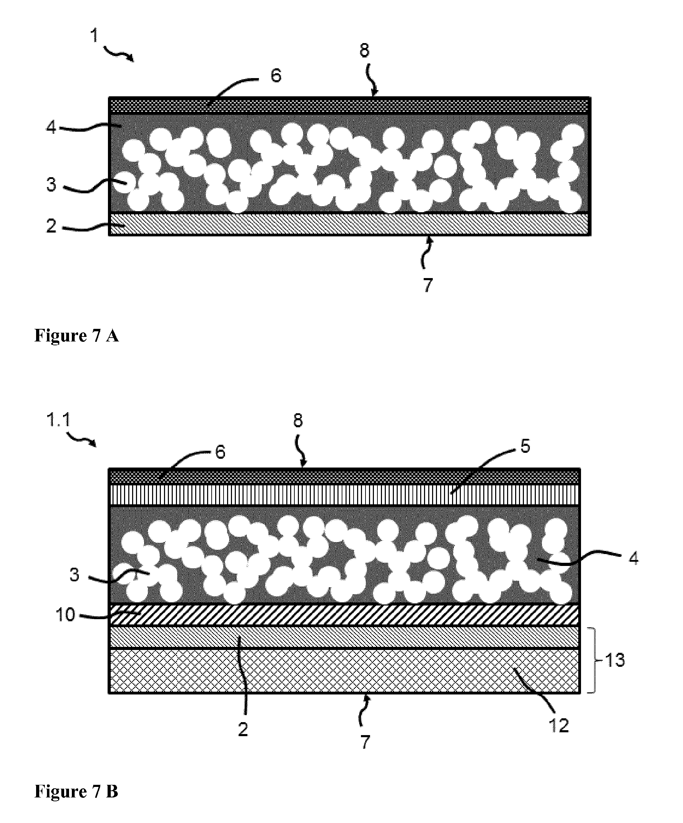

**Figures 7** **A** and **B** show exemplary solar cells 1, and 1.1. The same layers have the same reference numbers.

In the solar cell shown in **Figure 7A**, reference numeral 2 represents a current collector and/or a conductive layer. One side of said current collector 2 is oriented towards the bottom and/or outside of the cell and thus forms a first side 7 of the solar cell. The nanoporous layer 3 is provided on said current collector 2. Reference numeral 4 represents the perovskite layer, which is in direct contact with and/or on the nanoporous layer 3. The counter electrode 6, which may exemplary be made from a metal, provides the upper or second side 8 of the solar cell, oriented to the outside of the cell. Towards the inside, the counter electrode 6 is in direct contact with the perovskite layer 4. An intermediate layer 5 is absent in the solar cell shown in Figure 7 A. The perovskite layer 4 serves as sensitizer and/or as hole transport material. Upon illumination, electrons are exited in the perovskite layer and injected into the semiconductor material of the nanoporous layer 3. From there, the electrons are pushed via the current collector 2 to an external circuit (not shown). New electrons are taken from the external circuit (not shown) connected to the counter electrode 6, which injects the electrons into the perovskite layer 4, thereby closing the electric circuit.

Solar cell 1.1 shown in **Figure 7B** comprises a transparent support layer 12, forming a conductive support layer 13 together with current collector 2. An underlayer 10 and an intermediate layer 5 are present. The intermediate layer preferably comprises an organic hole transport material.

In an exemplary embodiment, the invention is based on the deposition of PbI₂ by solution processing on the nanocrystalline oxide scaffold in a first step and the subsequent transformation of the PbI₂ into the desired nanoscopic CH₃NH₃PbI₃ perovskite pigment by contacting with a solution of CH₃NH₃I in a solvent that does not dissolve readily the PbI₂.

We find that the reaction occurs within seconds and allows us to have much better control over the perovskite morphology compared to the previously employed route. We employ this method for the fabrication of perovskite-sensitized solar cells. The use of this new procedure results not only in an excellent reproducibility of photovoltaic device performance, but also enabled us to reach stable performance and a new record PCE of 15.0 % using spiro-MeOTAD as a hole transporter.

The present invention will now be further illustrated by way of examples. These examples do not limit the scope of this invention, which is defined by the appended claims.

### Examples:

### Preparation of perovskite nanocomposites

We prepared the mesoporous TiO₂ (anatase) films by spin-coating a solution of colloidal TiO₂ (anatase) particles onto a 30 nm thick compact TiO₂ underlayer. The latter was deposited by aerosol spray pyrolysis on a transparent conducting oxide (TCO) coated glass substrate acting as electric front contact of the solar cell. PbI₂ was then introduced into the TiO₂ nanopores by spin-coating using a 1.0 M solution in DMF kept at 70°C. Using such a high PbI₂ concentration is critical to obtain the high loading of the mesoporous TiO₂ films required to realize top performance solar cells. Further experimental details are provided in the methods section.

Figure 1a presents a cross-sectional SEM photograph of the thus prepared film. The absence of any protruding PbI₂ crystals from the surface of the mesoporous anatase layer shows that our infiltration method leads to a structure where the PbI₂ is entirely contained within the nanopores of the TiO₂ film. We find that the resulting composite has approximately the same optical absorbance as that of a 200 nm thick compact PbI₂ film and estimate from the optical measurements and the known film porosity of 70% that the fraction of the porous space in the mesoscopic anatase film occupied by lead iodide nanocrystals is about 60%.

Dipping the TiO₂/PbI₂ composite film into a solution of CH₃NH₃I in 2-propanol (10 mg ml⁻¹) changes its colour instantaneously from yellow to dark brown, indicating the formation of CH₃NH₃PbI₃- We monitored the dynamics of the insertion reaction by optical absorption and emission as well as X ray diffraction (XRD) spectroscopy. Figure 1b shows that the temporal growth of the perovskite absorption at 550 nm is practically complete a few seconds after exposing the PbI₂ loaded TiO₂ film to the CH₃NH₃I solution. A small additional increase of the absorbance occurring on a time scale of 100 s contributing only a few percent to the total increase of the signal is attributed to morphological changes producing enhanced light scattering. The conversion is accompanied by a quenching of the PbI₂ emission at 425 nm (Figure 1c) and a concomitant rise of the perovskite luminescence at 775 nm (Figure 1d). The latter emission passes through a maximum decreasing to a stationary value. This decrease arises from self-absorption of the luminescence by the perovskite formed during the insertion reaction. The traces were fitted to a biexponential function yielding the decay times inserted in the figure. Note that the rise of the emission intensity prior to the quenching in Figure 1c, is an optical artifact arising from opening the sample compartment for the addition of the CH₃NH₃I solution.

The green and red curves in Figure 1e show x-ray powder diffraction spectra measured prior and after contacting the TiO₂/PbI₂ nano-composite film with the CH₃NH₃I solution, respectively. For comparison we spin-coated the PbI₂ also on a flat glass substrate and exposed the resulting film in the same manner to a CH₃NH₃I solution as the TiO₂/PbI₂ nano-composite. From a comparison with literature data, the PbI₂ deposited by spin-coating from DMF solution crystallizes in the form of the hexagonal 2H polytype, the most common PbI₂ modification.²⁰ Moreover, the results show that on a flat glass substrate, crystals grow in a preferential orientation along the c-axis, hence the appearance of only four diffraction peaks that correspond to the (001), (002), (003) and (004) lattice planes (black curve, Figure 1e). For the PbI₂ loaded on a mesoporous TiO₂ film (green curve, Figure 1e), we find three additional diffraction peaks that do not originate from TiO₂, suggesting that the anatase scaffold induces a different orientation for the PbI₂ crystal growth. Only the peaks labeled as (2) and (3) in Figure 1e can be attributed to the (110) and (111) lattice planes of the 2H polytype. Peak (1) is assigned to a different PbI₂ variant whose identification is out of the scope of this report in view of the large number of polytypes that have been reported for PbI₂.²¹

During the insertion reaction, we observe the appearance of a series of new diffraction peaks that are in good agreement with literature data of the tetragonal phase of the CH₃NH₃PbI₃ perovskite.²² However when PbI₂ is deposited on a flat film (blue curve, Figure 1e) the conversion to perovskite upon contacting by the CH₃NH₃I solution is incomplete, a large amount of unreacted PbI₂ remaining present even after a dipping time of 45 minutes. This agrees with the observations of Liang et.al.²³, who reported that the CH₃NH₃I intercalation hardly proceeds beyond the surface of thin PbI₂ films, the complete transformation of the crystal structure requiring several hours. The caveat of such long conversion times is that the perovskite dissolves in the methylammonium iodide solution over longer periods, restricting the exposure time.and hampering the transformation

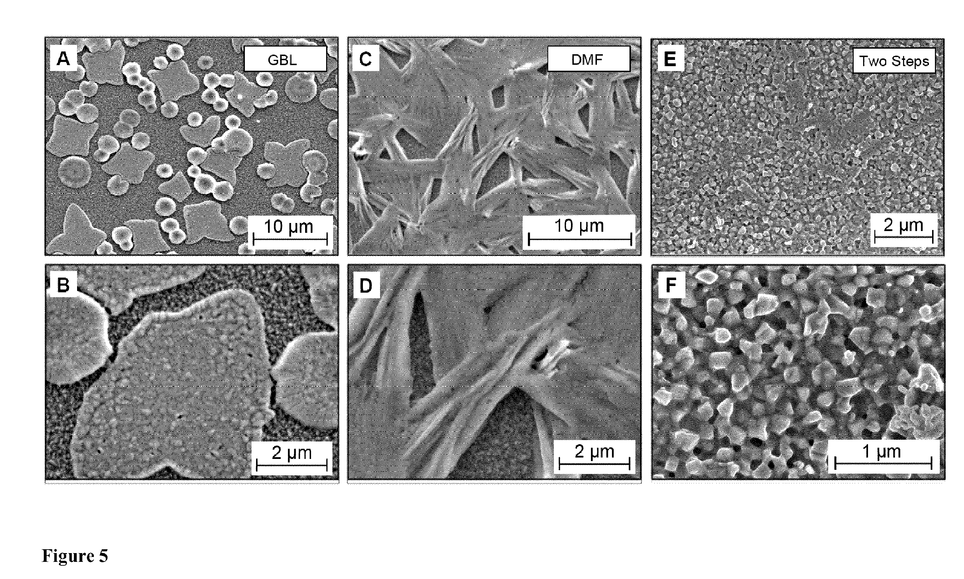

In striking contrast to the behavior of thin films of lead iodide deposited on a flat support, the conversion of PbI₂ nanocrystals in the mesoporous titania film is practically complete on a time scale of seconds as is evident from the immediate disappearance of its most intense (001) diffraction peak and the concomitant appearance of the XRD reflections for the tetragonal pervoskite. When the PbI₂ crystals are contained within the mesoporous TiO₂ scaffold their growth is limited to ca. 22 nm by the pore size of the host. Importantly we find that confining the PbI₂ crystals to such small size enhances dramatically their rate of conversion to the perovskite, which is complete within a few seconds of contacting by the methylammonium iodide solution. On the other hand, when deposited on a flat surface, larger PbI₂ crystallites in the size range of 50-200 nm are formed as shown by the SEM photographs presented in Figures 5 (e/f). Figure 5 also shows that big crystals of CH₃NH₃PbI₃ with a large size distribution are formed when the perovskite is deposited in a single step from a solution of CH₃NH₃I and PbI₂ in GBL or DMF.

Specifically, Figures 5 A-D) show CH₃NH₃PbI₃ deposited by spin-coating on a fluorine-doped tin oxide glass substrate using a mixed solution of PbI₂ and CH₃NH₃I (1:1, molar ratio) in A, B) y-butyrolactone (GBL) or C, D) N,N-dimethylformamide (DMF) solvent. In both cases the surface coverage is low and bare FTO is exposed. In Figures E, F) CH₃NH₃PbI₃ is obtained using the sequential deposition method. The dipping time of the PbI₂ film in the CH₃NH₃I/2-propanol solution was 30 s. Compared to the single-step method, the sequential deposition yields much smaller CH₃NH₃PbI₃ crystallites and full coverage of the FTO surface.

A key finding of the present work is that the confinement of the PbI₂ within the nanoporous network of the TiO₂ film greatly facilitates their conversion to the perovskite pigment. Moreover the mesoporous scaffold of the host forces the perovskite to adapt a similar nano-morphology as the PbI₂ precursor. As will be shown below such composite nanostructures are very efficient in harvesting sunlight and converting it to electric power, opening up a new pathway to realizing solar cells with excellent photovoltaic performance and stability.

### Photovoltaic performance

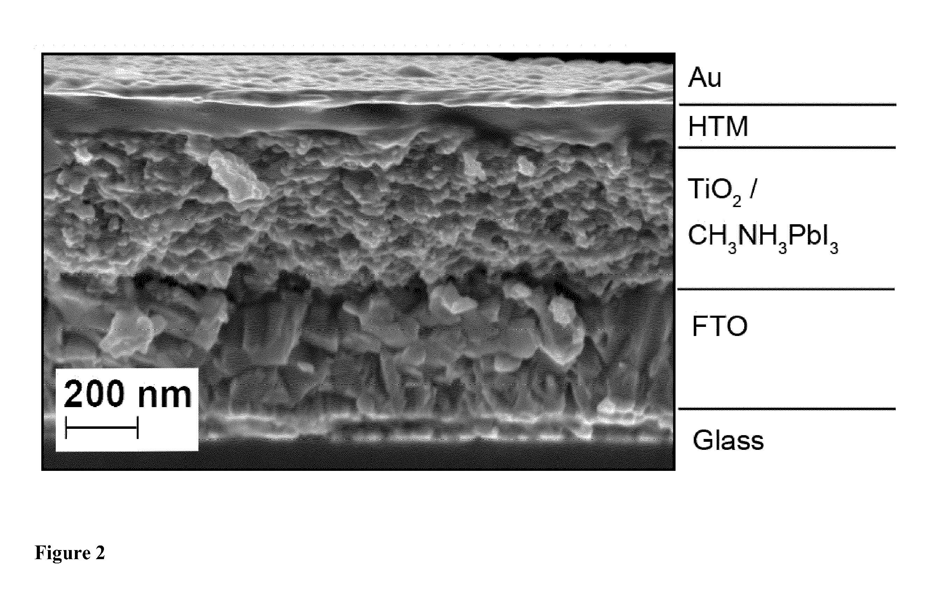

We used the sequential deposition technique to fabricate mesoscopic solar cells employing the triarylamine-derivative spiro-MeOTAD as a hole transport material (HTM). Figure 2 shows a cross sectional SEM picture of a typical device. The mesoporous TiO₂ film had an optimized thickness of around 350 nm and was infiltrated with the perovskite nanocrystals using the above-mentioned two-step procedure. The HTM was subsequently deposited by spin coating. It penetrates into the remaining available pore volume and forms a 100 nm thick overlayer on top of the composite structure. A thin gold layer was thermally evaporated under vacuum onto the HTM forming the back contact of the device.

We measured the current-voltage characteristics of the solar cells under simulated air mass (AM) 1.5 global (G) solar irradiation and in the dark. Figure 3a shows JV-curves measured at a light intensity of 95.6 mW cm⁻² for a typical device. From this we derive values for the short-circuit photocurrent (J_{SC}), open-circuit voltage (V_{OC}) and fill factor (FF) of 17.1 mA cm⁻², 992 mV and 0.73, respectively, yielding a PCE of 12.9% (Table 1). Statistical data on a larger batch of ten photovoltaic devices is shown in Table 2. From the average PCE value of 12.0 ± 0.5% and the small standard deviation we infer that photovoltaics with excellent performance and high reproducibility can be realized employing the new method reported herein.

Figure 3b shows the incident photon-to-electron conversion efficiency spectrum (IPCE) or external quantum efficiency (EQE) for the perovskite cell. Generation of photocurrent starts at 800 nm in agreement with the band gap of the CH₃NH₃PbI₃, reaching peak values of over 90% in the blue region of the spectrum. Integrating the overlap of the IPCE spectrum with the AM1.5G solar photon flux yields a current density of 18.4 mA cm⁻², which is in excellent agreement with the measured photocurrent density, extrapolated to 17.9 mA cm⁻² at the standard solar AM 1.5 intensity of 100 mW cm⁻². This confirms that any mismatch between the simulated sunlight and the AM1.5G standard is negligibly small. Comparison with the absorptance or light-harvesting-efficiency (LHE) depicted in Figure 3c reveals that the low IPCE values in the range of 600 to 800 nm result from the smaller absorption of the perovskite in this spectral region. This is also reflected in the spectrum of the internal quantum efficiency (IQE) or absorbed photon-to-electron conversion efficiency (APCE) that can be derived from IPCE and LHE and that is shown in Figure 3d. The APCE spectrum exhibits values above 90% over the whole visible region without correction for reflective losses indicating that the device achieves near unity quantum yield for the generation and collection of charge carriers.

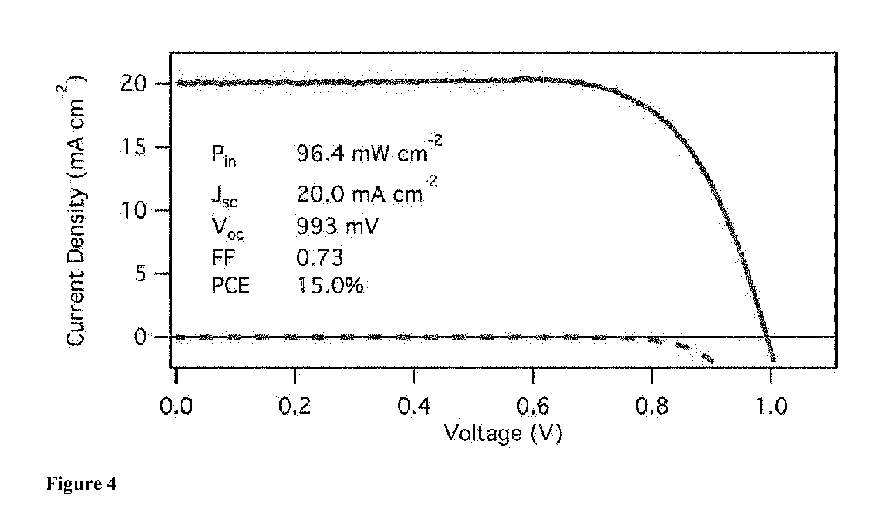

In an attempt to increase the loading of the perovskite absorber on the TiO₂ structure and obviate the lack of absorption in the red region of the spectrum, we slightly modified the conditions for the deposition of the PbI₂ precursor as well the transformation reaction. Details are provided in the experimental section. The JV-characteristics of a champion cell that was fabricated in this manner are depicted in Figure 4. From this data we derive values of 20.0 mA cm⁻², 993 mV and 0.73 for J_{sc}, V_{oc} and FF, respectively, yielding a PCE of 15.0% measured at a light intensity of 96.4 mW cm⁻². To the best of our knowledge, this is the highest power conversion efficiency reported so far for organic or hybrid inorganic/organic solar cells and any solution-processed photovoltaics. Compared to the data shown in Figure 3a, the device benefits from a significantly higher photocurrent that we attribute to the higher loading of the porous titania film with the perovskite pigment improving the red response of the cell.

### Long-term stability

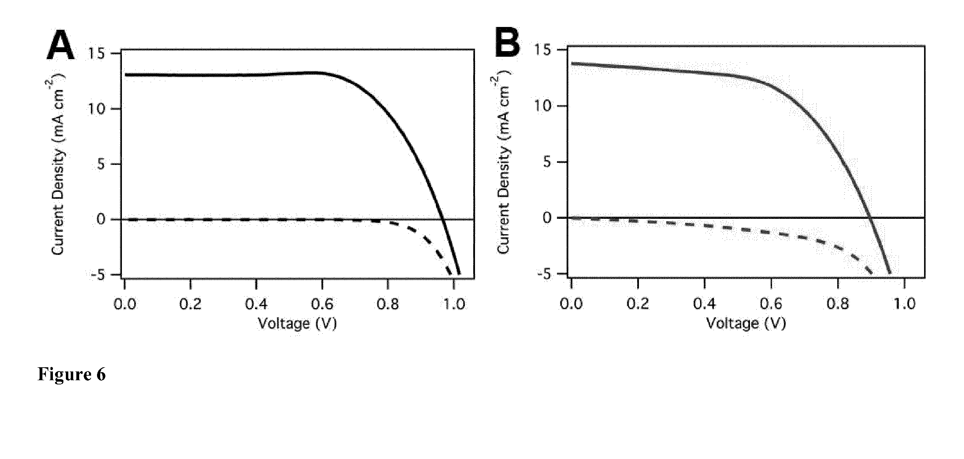

In order to test the stability of the perovskite based photovoltaics prepared using the aforementioned procedure we subjected a sealed cell to long term light soaking at ca. 100 mW cm⁻² light intensity and 45 °C. The device was encapsulated in argon and is maintained under optimal operating conditions during the ageing using maximum power point (MPP) tracking. We find a very promising long-term stability as the photovoltaic device maintains above 80% of its initial PCE after a period of 500 h. Even more importantly, we do not observe any change in short-circuit photocurrent, indicating that there is no photodegradation of the perovskite light-harvester. The decrease in PCE is therefore only due to a decrease in both open-circuit potential and FF, whereas the similar shape of both decays suggests that they are both linked to the same degradation mechanism. The change in these two parameters is due to a decrease in the shunt resistance as is apparent from Figure 6 where JV curves of the device prior and after the aging process are displayed.

### Conclusions

In conclusion, the sequential deposition method for the fabrication of perovskite sensitized mesoscopic solar cells introduced here, provides a means to achieve a excellent photovoltaic performance with high reproducibility. The power conversion efficiency of 15% achieved with the best device is a new record for solution-processed photovoltaics and organic or hybrid inorganic/organic solar cells in general. Our findings enable completely new routes for the fabrication of perovskite-based photovoltaic devices as any preformed metal halide structure may be converted into the desired perovskite by this simple insertion reaction. A key finding of our investigation is that the rate of conversion is greatly enhanced by confining the metal halide within the nano-pores of the metal oxide host that acts as a scaffold. Solar cells that were fabricated using this procedure exhibit not only excellent performance but also show very promising long-term stability under prolonged test conditions, raising hope that this new class of mesoscopic solar cells will find wide spread applications.

### METHODS SUMMARY:

**Device Fabrication.** Patterned TCO glass substrates were coated with TiO₂ compact layer by aerosol spray pyrolysis. A 350 nm thick mesoporous TiO₂ layer composed of 20 nm sized particles was then deposited by spin-coating. The mesoporous TiO₂ films were infiltrated with PbI₂ by spin coating a 1.0 M PbI₂ solution in DMF that was kept at 70 °C and subsequently dried at 70 °C for 30 min. To from the perovskite, the films were dipped in a solution of CH₃NH₃I in 2-propanol (10 mg ml⁻¹) for 20 s, rinsed with 2-propanol and dried at 70 °C for 30 min. The hole-transporting material was then deposited by spin-coating a solution of spiro-MeOTAD, 4-tert-butylpyridine, lithium bis(trifluoromethylsulfonyl)imide and Tris(2-(1H-pyrazol-1-yl)-4-tert-butylpyri-dine)cobalt(III) tris(bis(trifluoromethylsulfonyl)imide)) in chlorobenzene. 80 nm of gold were thermally evaporated on top of the device to form the back contact. For the fabrication of the champion device, slightly modified conditions were used: Firstly, PbI₂ was spin-cast for 5 s instead of 90 s and secondly, the samples were subjected to a 'pre-wetting' by dipping in 2-propanol for 1-2 s prior to the dipping in the CH₃NH₃I/2-propanol solution.

Device Characterization. Current-Voltage-Characteristics were recorded by applying an external potential bias to the cell while recording the generated photocurrent with a digital source meter. All measurements were conducted using a metal aperture of 0.285 cm² to define the active area of the device.

**Long-term stability.** Devices were sealed in argon using a hot-melting polymer and subjected to constant light-soaking at approximately 100 mW cm⁻². The light source was an array of white LEDs. During the testing, the devices were maintained at their maximum power point (MPP) by electronic control and a temperature of about 45 °C. JV -curves were recorded automatically every 2 hours.

**Optical spectroscopy.** Mesoporous TiO₂ films were deposited on microscopic glass slides and infiltrated with PbI₂ following the above-mentioned procedure. The samples were then placed vertically in a cuvette of 10 mm path length. A solution of CH₃NH₃I in 2-propanol was then rapidly injected into the cuvette while monitoring either the photoluminescence or the optical transmission.

### REFERENCES:

1. Hagfeldt, A.; Boschloo, G.; Sun, L.; Kloo, L.; Pettersson, H. Dye-sensitized solar cells. Chem. Rev. 2010, 110, 6595-6663.
2. Bach, U. et al. Solid-state dye-sensitized mesoporous TiO2 solar cells with high photon-to-electron conversion efficiencies. Nature 1998, 395, 583-585*.*
3. Chung, I.; Lee, B.; He, J.; Chang, R. P. H.; Kanatzidis, M. G. All-solid-state dye-sensitized solar cells with high efficiency. Nature 2012, 485, 486-489**.**
4. Burschka, J. et al. Tris(2-(1H-pyrazol-1-yl)pyridine)cobalt(III) as p-type dopant for organic semiconductors and its application in highly efficient solid-state dye-sensitized solar cells. J. Am. Chem. Soc. 2011, 133, 18042-18045.
5. Yella, A. et al. Porphyrin-sensitized solar cells with cobalt (II/III)-based redox electrolyte exceed 12 percent efficiency. Science 2011, 334, 629-634*.*
6. Schmidt-Mende, L.; Zakeeruddin, S. M.; Grätzel, M. Efficiency improvement in solid-state-dye-sensitized photovoltaics with an amphiphilic ruthenium-dye. Appl. Phys. Lett. 2005, 86, 013504.
7. Hodes, G.; Cahan, D. All-solid-state, semiconductor-sensitized nanoporous solar cells. Acc. Chem. Res. 2012, 45, 705-713. 8.
8. Ning†, D , Zhitomirsky†,D, Adinolfi, V, Sutherland, B, Xu,,J, Voznyy, O, Maraghechi, P, Lan, X, Hoogland, S, Yuan, R, Sargent E.H. Graded doping for enhanced colloidal quantum dot photovoltaics. Adv. Mater. 2013, 25,1719-1723.
9. Kojima, A.; Teshima, K.; Shirai, Y.; Miyasaka, T. Organometal halide perovskites as visible-light sensitizers for photovoltaic cells. J. Am. Chem. Soc. 2009, 131, 6050-6051.
10. Im, J.-H. et al. 6.5% efficient perovskite quantum-dot-sensitized solar cell. Nanoscale 2011, 3, 4088-4093.
11. Kim, H.-S. et al. Lead iodide perovskite sensitized all-solid-state submicron thin film mesoscopic solar cell with efficiency exceeding 9%. Sci. Rep. 2012, 2, 591.
12. Lee, M. M.; Teuscher, J.; Miyasaka, T.; Murakami, T. N.; Snaith, H. J. Efficient hybrid solar cells based on meso-superstructured organometal halide perovskites. Science 2012, 338, 643-647.
13. Etgar, L. et al. Mesoscopic CH3NH3PbI3/TiO2 heterojunction solar cells. J. Am. Chem. Soc. 2012, 134, 17396-17399.
14. Im, J.-H.; Chung, J.; Kim, S.-J.; Park, N.-G. Synthesis, structure, and photovoltaic property of a nanocrystalline 2H perovskite-type novel sensitizer (CH3CH2NH3)PbI3. Nanoscale Res. Lett. 2012, 7, 353.
15. Edri, E.; Kirmayer, S.; Cahen, D.; Hodes, G. High open-circuit voltage solar cells based on organic-inorganic lead bromide perovskite. Phys. Chem. Lett. 2013, 4, 897-902.
16. Crossland, E. J. W. et al. Mesoporous TiO2 single crystals delivering enhanced mobility and optoelectronic device performance. Nature 2013, 495, 215-219*.*
17. Noh, J. H.; Im, S. H.; Heo, J. H.; Mandal, T. N.; Seok, S. I. Chemical management for colorful, efficient, and stable inorganic-organic hybrid nanostructured solar cells. Nano Lett. 2013**,** DOI: 10.1021/n1400349b.
18. Cai, B.; Xing, Y.; Yang, Z.; Zhang, W.-H.; Qiu, J. High performance hybrid solar cells sensitized by organolead halide perovskites. Energy Environ. Sci. 2013**,** DOI: 10.1039/c3ee40343b.
19. Qui, J. et al. All-solid-state hybrid solar cells based on a new organometal halide perovskite sensitizer and one-dimensional TiO2 nanowire arrays. Nanoscale 2013, 5, 3245-3248.
20.ICSD Collection Code 68819, *Inorganic Crystal Structure Database* (ICSD, http://www.fiz-karlsruhe.com/icsd.html).
21. Beckmann, A. A review of polytypism in lead iodide. Cryst. Res. Technol. 2010, 45, 455-460.
22. Baikie, T. et al. Synthesis and crystal chemistry of the hybrid perovskite (CH3NH3)PbI3 for solid-state sensitized solar cell applications. J. Mater. Chem. A 2013**,** DOI: 10.1039/c3ta10518k.
23. Liang, K.; Mitzi, D. B.; Prikas, M. T. Synthesis and characterization of organic-inorganic perovskite thin films prepared using a versatile two-step dipping technique. Chem. Mater. 1998, 10, 403-411.

### TABLES:

**Table 1. PV performance at different light intensities.**

| **Intensity** | **J_{sc}** | **V_{oc}** | **FF** | **PCE** |
|---|---|---|---|---|
| *mW cm⁻²* | *mA cm⁻²* | *mV* | - | % |
| 9.3 | 1.7 | 901 | 0.77 | 12.6 |
| 49.8 | 8.9 | 973 | 0.75 | 13.0 |
| 95.6 | 17.1 | 992 | 0.73 | 12.9 |

**Table 2. Experimental spread of PV performance.**

| **Cell** | **V_{oc}** | **J_{sc}** | **FF** | **PCE** |
|---|---|---|---|---|
| - | *mV* | *mA cm⁻²* | - | % |
| **1** | 990 | 17.8 | 0.70 | 12.2 |
| **2** | 996 | 17.7 | 0.72 | 12.6 |
| **3** | 971 | 17.1 | 0.71 | 11.7 |
| **4** | 992 | 17.9 | 0.73 | 12.9 |
| **5** | 978 | 16.3 | 0.71 | 11.4 |
| **6** | 962 | 16.9 | 0.73 | 11.9 |
| **7** | 972 | 18.1 | 0.68 | 12.0 |
| **8** | 986 | 17.4 | 0.71 | 12.2 |
| **9** | 963 | 17.5 | 0.69 | 11.5 |
| **10** | 959 | 17.6 | 0.66 | 11.2 |
| | | | | |
| **Average** | **977 ± 14** | **17.4 ± 0.5** | **0.70 ± 0.02** | **12.0 ± 0.5** |

### METHODS SECTION:

**Materials.** Unless stated otherwise, all materials were purchased from Sigma-Aldrich (Switzerland) or Acros Organics (Belgium) and used as received. Spiro-MeOTAD was purchased from Merck KGaA (Germany). CH₃NH₃I was synthesized according to a reported procedure.¹¹

**Device Fabrication.** First, laser-patterned, fluorine-doped tin-oxide (FTO) coated glass substrates (Tec15, Pilkington) were cleaned by ultrasonication in an alkaline, aqueous washing solution, rinsed with deionized water, ethanol and acetone and subjected to a O₃/UV treatment for 30 min. A 20-40 nm thick TiO₂ compact layer was then deposited on the substrates by aerosol spray pyrolysis at 450 °C using a commercial titanium diisopropoxide bis(acetylacetonate) solution (30% in 2-propanol, Sigma-Aldrich) diluted in ethanol (1:39, volume ratio) as precursor and oxygen as carrier gas. After cooling to room temperature the substrates were then treated in an 0.02 M aqueous solution of TiCl₄ for 30 min at 70 °C, rinsed with deionized water and dried at 500 °C during 20 min. The mesoporous TiO₂ layer composed of 20 nm sized particles was deposited by spin-coating at 5000 rpm for 30 s using a commercial TiO₂ paste (Dyesol 18NRT, Dyesol), diluted in ethanol (2:7, weight ratio). After drying at 125 °C, the TiO₂ films were gradually heated to 500 °C, baked at this temperature for 15 min and cooled to room temperature. Prior to their use, the films were again dried at 500 °C for 30 min. PbI₂ was dissolved in N,N-dimethylformamid under vigorous stirring and the solution kept at 70 °C during the deposition. The mesoporous TiO₂ films were then infiltrated with PbI₂ by spin coating a 1.0 M PbI₂ solution at 6500 rpm for 90 s and dried at 70 °C for 30 min. After cooling to room temperature, the films were dipped in a solution of CH₃NH₃I in 2-propanol (10 mg ml⁻¹) for 20 s, rinsed with 2-propanol and dried at 70 °C for 30 min. The hole-transporting material was then deposited by spin-coating at 4000 rpm for 30 s. The spin-coating formulation was prepared by dissolving 72.3 mg (2,2',7,7'-tetrakis(N,N-di-p-methoxyphenylamine)-9,9-spirobifluorene) (spiro-MeOTAD), 28.8 µl 4-tert-butylpyridine (TBP), 17.5 µl of a stock solution of 520 mg ml⁻¹ lithium bis(trifluoromethylsulfonyl)imide (LiTFSI) in acetonitrile and 29 µl of a stock solution of 300 mg ml⁻¹ Tris(2-(1H-pyrazol-1-yl)-4-tert-butylpyri-dine)cobalt(III) tris(bis(trifluoromethylsulfonyl)imide)) in acetonitrile in 1 ml chlorobenzene. Finally 80 nm of gold were thermally evaporated on top of the device to form the back contact. The device fabrication was carried out under controlled atmospheric conditions and a humidity of <1%. For the fabrication of the champion device exhibiting a PCE of 15%, slightly modified conditions were used: Firstly, PbI₂ was spin-cast at 6500 rpm for 5 s. Secondly, the samples were subjected to a 'pre-wetting' by dipping in 2-propanol for 1-2 s prior to the dipping in the CH₃NH₃I/2-propanol solution.

**Device Characterization.** Current-Voltage-Characteristics were recorded by applying an external potential bias to the cell while recording the generated photocurrent with a digital source meter (Keithley Model 2400). The light source was a 450 W xenon lamp (Oriel) equipped with a Schott K113 Tempax sunlight filter (Praezisions Glas & Optik GmbH) in order to match the emission spectrum of the lamp to the AM1.5G standard. Incident photon-to-electron conversion efficiency (IPCE) spectra were recorded as function of wavelength under a constant white light bias of approximately 5 mW/cm² supplied by a white LED array. The excitation beam coming from a 300 W xenon lamp (ILC Technology) was focused through a Gemini-180 double monochromator (Jobin Yvon Ltd.) and chopped at approximately 2 Hz. The signal was recorded using a Model SR830 DSP Lock-In Amplifier (Stanford Research Systems). All measurements were conducted using a non-reflective metal aperture of 0.285 cm² to define the active are of the device and avoid light scattering through the sides.

**Longterm Stability.** For long-term stability tests, the devices were sealed in argon using a 50 µm thick hot-melting polymer and a microscopic cover slide and subjected to constant light-soaking at approximately 100 mW cm⁻². The light source was an array of white LEDs (LXM3-PW51 4000K, Philips). During the testing, the devices were maintained at their maximum power point (MPP) using MPP-tracking and a temperature of about 45 °C. An automatic IV measurement at different light intensities (0%, 1%, 10%, 50% and 100% sun) was taken every 2 h.

**Optical spectroscopy.** Mesoporous TiO₂ films were deposited on microscopic glass slides and infiltrated with PbI₂ following the above-mentioned procedure. The samples were then placed vertically in a standard cuvette of 10 mm path length using a Teflon holder. A solution of CH₃NH₃I in 2-propanol was then rapidly injected into the cuvette while monitoring either the photoluminescence or the optical transmission. Photoluminescence measurements were carried out on a Horiba Jobin Yvon Fluorolog spectrofluorometer. Optical absorption measurements were carried out on a Varian Cary 5 spectrophotometer.

**X-ray diffraction (XRD) measurements.** For XRD measurements TiO₂ and TiO₂/PbI₂ nanocomposites were deposited on microscopic glass slides using the above-mentioned procedures. X-ray powder diagrams were recorded on an X'Pert MPD PRO from PANalytical equipped with a ceramic tube (Cu-anode, □=1.54060 Å), a secondary graphite (002) monochromator and a RTMS X'Celerator detector, and operated in BRAGG-BRENTANO geometry. The samples were mounted as *is,* and the automatic divergence slit and beam mask were adjusted to the dimensions of the thin films. A step size of 0.008 ° was chosen and an acquisition time of up to 7.5 min/°.

## Claims

1. A method for producing a solar cell, the method comprising the steps of:
- providing a current collector and a nanoporous layer;
- applying and/or depositing a film comprising one or more divalent or trivalent metal salts on said nanoporous layer;
- exposing and/or contacting the film obtained in the previous step to a solution comprising one or more organic ammonium salts in a solvent, thereby obtaining a layer comprising an organic-inorganic perovskite; and
- providing a counter electrode.

2. A method for producing a nanocrystalline organic-inorganic perovskite layer, the method comprising the steps of:
- providing a nanoporous layer;
- applying and/or depositing a film of one or more divalent or trivalent metal salts on said nanoporous layer;
- exposing and/or contacting the film obtained in the previous step to a solution comprising one or more organic ammonium salts in a solvant, thereby obtaining a layer comprising an organic-inorganic perovskite.

3. The method of any one of the preceding claims, wherein said organic-inorganic perovskite is formed within < 120 s, preferably < 60 s following exposure to said solution.

4. The method of any one of the preceding claims, wherein the size of crystals of said metal salt and/or of said organic-inorganic perovskite obtained in the method of the invention are < 50 nm, preferably < 45 nm, more preferably < 40 nm.

5. The method of any one of the preceding claims, wherein said metal salt film is exposed for 10 minutes or less to said solution.

6. The method of any one of the preceding claims, wherein a layer comprising said perovskite is substantially free of said one or more metal metal salts.

7. The method of any one of the preceding claims, wherein said film of said one or more divalent or trivalent metal salts is applied and/or deposited by any one or more methods selected from: deposition from solution, deposition from a dispersion (for example, from a colloidal dispersion), deposition by thermal evaporation or sputtering, electrodeposition, atomic-layer-deposition (ALD), and formation of said metal salt in-situ.

8. The method of any one of the preceding claims, wherein said film of said one or more divalent or trivalent metal salts is applied and/or deposited by spin-coating a solution of said metal salt at 3'000 rpm or more, preferably 4'000 rpm or more.

9. The method of any one of the preceding claims, wherein, before exposing the film of said one or more metal salt to said organic ammonium halide solution, said film is pre-wetted by exposing it to a solvent in the absence of said organic ammonium halide.

10. The method of any one of the preceding claims, wherein 2H polytype crystals of said divalent metal salt are formed on said nanoporous scaffold layer, and additional crystals of said one or more metal salt, which are different from said 2H polytype.

11. The method of any one of the preceding claims, wherein said nanoporous layer is **characterized by** one or more of the following features:
- it has a surface area per gram ratio of 20 to 200 m²/g, preferably 30 to 150 m²/g, and most preferably 60 to 120 m²/g;
- it comprises and/or is prepared from nanoparticles, such as nanosheets, nanocolumns and/or nanotubes;
- it is nanocrystalline;
- it is mesoporous;
- it has an overall thickness of 10 to 3000 nm, preferably 15 to 1500 nm, more preferably 20 to 1000 nm, still more preferably 50 to 800 nm and most preferably 100 to 500 nm;
- it has a porosity of 20 to 90%, preferably 50 to 80%;
- it comprises and/or consists essentially of a metal oxide and/or a semiconductor material.

12. The method of any one of the preceding claims, wherein said one or more divalent or trivalent metals salts, respectively, have the formula MX₂ and NX₃;
wherein M is a divalent metal cation selected from the group consisting of Cu²⁺, Ni²⁺, Co²⁺, Fe²⁺, Mn²⁺, Cr²⁺, Pd²⁺, Cd²⁺, Ge²⁺, Sn²⁺, Pb²⁺, Eu²⁺, or Yb²⁺;
N is selected from the group of Bi³⁺ and Sb³⁺;
any X is independently selected from Cl⁻, Br⁻, I⁻, NCS⁻, CN⁻, and NCO⁻;
wherein said organic ammonium salt is selected from AX, AA' X₂, and BX₂, A and A' being independently selected from organic, monovalent cations selected from primary, secondary, tertiary or quaternary organic ammonium compounds, including N-containing heterorings and ring systems, A and A' having from 1 to 60 carbons and 1 to 20 heteroatoms; and B being an organic, bivalent cation selected from primary, secondary, tertiary or quaternary organic ammonium compounds having from 1 to 60 carbons and 2 to 20 heteroatoms and having two positively charged nitrogen atoms.

13. The solar cell obtainable by claim 1 or any one of claims 3 to 12.

14. The perovskite layer obtainable by any one of claims 2 to 12.

15. A solar cell comprising a nanoporous layer and an organic-inorganic perovskite layer in contact with said layer, wherein said perovskite comprises an organic-inorganic perovskite forming crystals of a length of < 50 nm, preferably < 45 nm, more preferably < 40 nm.

16. A solar cell comprising organic-inorganic perovskite layer in contact with a nanoporous layer, wherein said solar cell exhibits a power conversion efficiency (PCE) of ≥ 12%, preferably ≥ 13% when exposed to AM1.5G light.
